(19) Europäisches Patentamt
European Patent Office
Office européen des brevets

(11) EP 2 736 053 B1

(12) EUROPEAN PATENT SPECIFICATION

(45) Date of publication and mention
of the grant of the patent:
**01.03.2017 Bulletin 2017/09**

(51) Int Cl.:
*H01F 19/06* (2006.01)  *H01F 27/28* (2006.01)
*H03H 7/09* (2006.01)  *H04B 1/00* (2006.01)

(21) Application number: **12194068.8**

(22) Date of filing: **23.11.2012**

(54) **Radio broadcast receivers**

Funkrundfunkempfänger

Récepteur de diffusion radio

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**28.05.2014 Bulletin 2014/22**

(73) Proprietor: **NXP B.V.**
**5656 AG Eindhoven (NL)**

(72) Inventor: **Hafemeister, Thomas**
**5656 AG Eindhoven (NL)**

(74) Representative: **Schouten, Marcus Maria et al**
**NXP B.V.**
**Intellectual Property & Licensing**
**High Tech Campus 60**
**5656 AG Eindhoven (NL)**

(56) References cited:
EP-A2- 2 288 039  WO-A1-03/041312
WO-A1-03/073550  WO-A1-2011/118020
DE-A1- 4 203 961  GB-A- 1 470 695
US-A- 4 894 629  US-A1- 2004 142 669
US-A1- 2004 145 410  US-A1- 2008 111 652
US-A1- 2010 231 326

• DATABASE WPI Week 199525 Thomson
Scientific, London, GB; AN 1995-189397
XP002695205, -& JP 7 106896 A (NIPPON
CEMENT KK) 21 April 1995 (1995-04-21)

**Description**

This invention relates to band pass filter designs, in particular for radio broadcast applications, for example in the field of car entertainment.

Band pass filters in receiver applications are required to provide interfacing and filtering functions including impedance matching between the antenna (active and passive) and input electronics, the band pass filtering, and optionally also conversion from single ended input to symmetrical output.

Known filter designs for band pass filtering for in-car radio broadcasts receiver applications are based on a combination of coils and transformers together with capacitors, all in surface mount device ("SMD") technology. The component effort per band for multi tuner use cases is quite high. The coils and transformers in particular are components with high value, and these are also used for impedance transformation and for single ended to symmetrical conversion. Generally, support for a symmetrical output is required, as radio broadcast receiver electronics is mainly based on a symmetric input configuration.

For the above described filter application, the transformer is designed to achieve the maximum mutual coupling between its coils, and the degree of mutual coupling itself is not a primary filter design parameter. In a different, more compact configuration, the degree of mutual coupling is used to shape the filter design.

DE 42 03 961 A1 describes a filter that comprises a protective plate, an upper dielectric plate with a two-coil electrode structure, a number of intermediate dielectric plates (optionally featuring trimming electrode structures), and a lower dielectric plate with a central single-plate electrode. The coils on the upper plate are magnetically coupled and have two chassis connection tracks and two signal connection tracks. These tracks are arranged on opposite edges of the dielectric plate and their relative separation distance is determined by the required filter impedance. External connectors are fitted to the ends of the upper dielectric signal tracks, while further connecting tracks are arranged on opposite edges of the lower plate electrode.

GB 1 470 695 A describes a printed band pass filter, in which a conductor (L2) is formed by printed conductors on opposite sides of substrate, interconnected at a through hole, an inductor (L3) is formed by printed conductors on opposite sides of substrate and again interconnected at a through hole and the mutual inductance between L2 and L3 is selected to have a desired value by the disposition of a printed conductor connected to the two inductors at a zone P and extending from zone P to an electrode. The mutual inductance is adjustable by a trimming conductor near zone P. The filter also includes an arrangement for reducing spurious signals.

JPH07106896 A describes plural spiral coils that are printed on an upper side of a dielectric layer and an inner conductor that is printed on the upper side of a dielectric layer corresponding to the number and position of the spiral coils. Moreover, outer conductors are printed onto the upper side of a dielectric layer and a lower side of a dielectric layer. The dielectric layers are overlapped and adhered to connect each capacitor formed by the layers with an inner conductor inbetween in series with the spiral coils.

WO 03/073550 A1 describes a band pass filter that is formed on an integrated circuit (IC) chip. The band pass filter includes a transformer (made of a pair of metallic spirals formed on the IC chip. The metallic spirals may have substantially square or rectangular overall shape, and may be fabricated using copper. The metallic spirals may be co-planar and inter-wound or may be stacked, one on top of the other, and separated by a dielectric layer. The transformer is capable of receiving an input signal, and providing high pass filtering to the input signal. The band pass filter also includes a capacitor that is capable of receiving the input signal and providing low pass filtering in conjunction with an inductance of the transformer. The band pass filter provides band pass filtering through cascading said high pass and low pass filtering.

According to the invention, there is provided an apparatus as claimed in claim 1.

According to one aspect of the invention, there is provided a radio broadcast receiver, comprising an electric circuit having at least one transformer device forming part of a band pass filter circuit, wherein the at least one transformer device comprises a pair of mutually coupled inductor coils formed as printed circuit board tracks.

The invention makes use of mutually coupled PCB track coils to replace the transformer used in known receiver circuits. The resulting filter circuit can be used for FM radio and DAB VHF bands. Using mutually coupled PCB track coils reduces the component effort for standard use cases and enables new applications with low effort such as a switched "band split" filter for splitting between FM (VHF II) and DAB (VHF III) or for use as a tuned narrow bandwidth filter tuned over an entire band. The narrow bandwidth filter can for example have a 10MHz band width - and can be tuned over the entire DAB (VHF III) band.

The mutually coupled coils are realized by using appropriate conductor patterns on printed circuit boards (PCBs) (also known as printed wiring boards), such that the filter function requires only additional capacitors, which additionally eases the implementation effort.

The inductor coils are preferably formed as tracks on both sides of a double-sided printed circuit board. Design parameters like degree of mutual coupling and inductivity can be set via layout geometry.

In a first example, each coil comprises a first set of parallel tracks on one side and a second set of parallel tracks on the other side, with through vias making connections to form a continuous coil, wherein the parallel tracks of one coil are interleaved with the parallel tracks of the other coil. This defines two interleaved coils. The magnetic field between the coils is parallel to the circuit board, whereas the magnetic field between adjacent tracks is perpendicular to the board.

In a second example, each coil comprises a first set of parallel tracks on one side and a second set of parallel tracks on the other side, with through vias making connections to form a continuous coil, wherein the coils are aligned with one next to the other. This version provides lower parasitic capacitances.

Each coil can comprise at least two sub-coils in series, wherein a line of sub-coils is formed, alternating between sub-coils of one coil and sub-coils of the other coil. Compared to the interleaved parallel tracks, the split into sub-coils provides more distance between the primary and secondary coils, which reduces the parasitic capacitance between the different coils.

In a third example, each coil comprises a planar coil, with one coil formed on one side of the printed circuit board and the other coil formed on the other side of the printed circuit board. This uses a vertical magnetic field coupling between the coils.

In a fourth example, the coils comprise interleaved spirals formed on one side of the printed circuit board, with terminal connections to the central ends of the spirals formed using connections on the other side of the printed circuit board. All terminal connections to the spiral ends can however be on the same side of the printed circuit board as the coils, with connections providing routing down to the opposite side of the circuit board from the central coil ends and back up to terminals on the coil side of the circuit board.

A ground plane can be provided on the opposite side of the printed circuit board to the coils. This ground plane can have an opening surrounding a connection so that the connection is isolated from the ground plane. Another connection to the central end of one of the spirals can be formed by the ground plane itself.

Each coil can comprise one of the interleaved spirals and two further coils at the two ends of the interleaved spiral. This design can be supplemented by a shielding layer. The shielding can be placed on the opposite side by a ground metal plane. Implementation of shielding is advantageous to isolate from possible interfering fields. Additionally this enables simple implementation of coil center taps for ground referencing.

In a fifth example, each coil comprises a loop with one coil loop parallel to the other and both formed on one side of the printed circuit board.

The invention also provides a receiver comprising a first band pass filter for passing the FM radio band and which uses a first transformer device of the invention, and a second band pass filter for passing the DAB III radio band and which uses a second transformer device of the invention. The band pass filter of the invention can thus be used for band selection.

A switchable band pass filter can be used for switching between a first band pass mode passing the FM radio band and a second band pass mode passing the DAB III radio band. This reduces the number of inputs required.

In one example, a receiver comprises two tuners, a first tuner having a wide band receiver of the invention for selecting between FM and DAB bands, and a second tuner which comprises a first band pass filter for passing the FM radio band and which uses a first transformer device, and a second band pass filter for passing a selected sub-band within the DAB III radio band and which uses a second transformer device. This uses a narrower band DAB filter. By appropriate variation of those capacitors, which are related to filter function, this narrower filter can be tuned in center frequency.

Examples of the invention will now be described in detail with reference to the accompanying drawings, in which:

Figure 1 shows the basic element of an RF receiver circuit of the invention;
Figure 2 shows first performance indicators for the circuit of Figure 1;
Figure 3 shows second performance indicators for the circuit of Figure 1;
Figure 4 shows the circuit of Figure 1 together with matching components;
Figure 5 shows first performance indicators for a conventional transformer based receiver circuit;
Figure 6 shows second performance indicators for a conventional transformer based receiver circuit;
Figure 7 shows third performance indicators for a conventional transformer based receiver circuit;
Figure 8 shows a circuit of the invention;
Figure 9 shows first performance indicators for the circuit of Figure 8;
Figure 10 shows second performance indicators for the circuit of Figure 8;
Figure 11 shows third performance indicators for the circuit of Figure 8;
Figure 12 shows a first way to implement the coupled coil design used in the circuit of Figure 8;
Figure 13 shows a second way to implement the coupled coil design used in the circuit of Figure 8;
Figure 14 shows a third way to implement the coupled coil design used in the circuit of Figure 8;
Figure 15 shows a fourth way to implement the coupled coil design used in the circuit of Figure 8;
Figure 16 shows a fifth way to implement the coupled coil design used in the circuit of Figure 8;
Figure 17a shows a sixth way to implement the coupled coil design used in the circuit of Figure 8;
Figure 17b shows variation on the sixth way to implement the coupled coil design used in the circuit of Figure 8;
Figure 18 shows a seventh way to implement the coupled coil design used in the circuit of Figure 8;
Figure 19 shows an eighth way to implement the coupled coil design used in the circuit of Figure 8;

Figure 20 shows a comparison of the characteristics of the circuits of Figures 12 to 19;

Figure 21 shows a first example of dual tuner receiver using the receiver circuit of the invention;

Figure 22 shows a second example of dual tuner receiver using the receiver circuit of the invention;

Figure 23 shows a third example of dual tuner receiver using the receiver circuit of the invention;

Figure 24 shows a fourth example of dual tuner receiver using the receiver circuit of the invention;

Figure 25 shows an implementation of tuneable filter as used in the circuits of Figures 23 and 24;

Figure 26 shows a tuneable capacitor bank for use in the tuneable filter of Figure 25;

Figure 27 shows the performance of the tuneable filter of Figure 25;

Figure 28 shows an implementation of switchable filter as used in the circuits of Figures 22 and 24;

Figure 29 shows the performance of the switchable filter of Figure 28; and

Figure 30 shows a circuit, which demonstrates the usability of the invention for scanning antenna diversity.

Figure 31 shows the performance of the invention using the circuit of Figure 30;

Figure 32 shows a conventional filter implementation using a transformer with high mutual coupling coefficient and transformer ratio >1;

Figure 33 shows an alternative filter implementation using a SMD coil in conjunction with the mutual coupled coils from Figure 17b;

Figure 34 shows the performance of the alternative filter implementation of Figure 33;

Figure 35 shows an active filter implementation in conjunction with the mutual coupled coils from Figure 17a; and

Figure 36 shows the performance of the active filter implementation of Fig.35.

The invention provides a radio broadcast receiver, comprising an electric circuit having at least one transformer device forming part of a band pass filter circuit. The at least one transformer device comprises a pair of mutually coupled inductor coils formed as printed circuit board tracks. This design uses PCB tracks to form mutually coupled coils, i.e. a transformer function. The non-perfect electromagnetic coupling (degree of mutual coupling expressed by the k-factor) provided by the PCB implementation is used to advantage as part of the design parameter of an RF broadcast receiver.

The band selection function of a radio broadcast service is supported by RF band pass filtering, which is generally performed by LC band pass filter designs together with transformers.

The invention provides a band pass filter function which uses a transformer-type structure, which is designed with a specific magnetic coupling degree and inductance. In this case the coil coupling degree can be expressed by a coupling factor "k". The term "transformer" is commonly used in the sense of coils with maximum magnetic coupling. In this application term "mutually coupled coils" is used instead, to emphasis the parameter "k" for magnetic coupling.

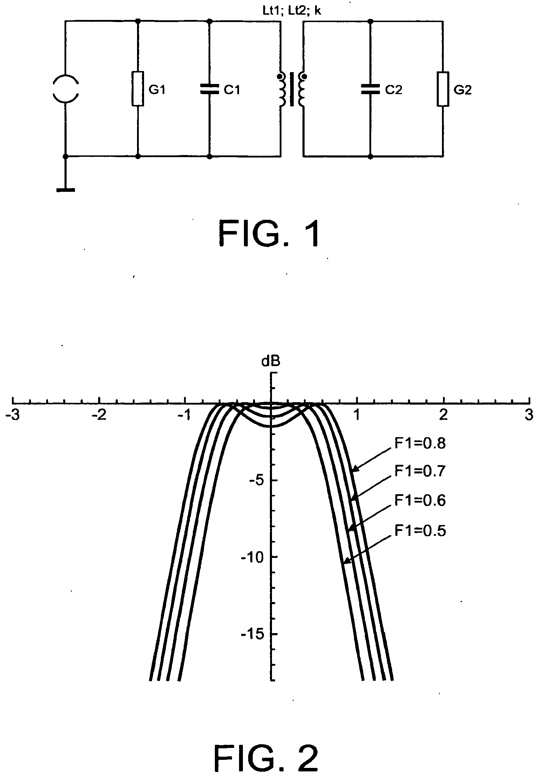

Figure 1 shows an example of the basic components of a mutually coupled band pass filter (BPF) of the invention. The mutually coupled coils are characterized by their inductances at the input and output (Lt1 and Lt2) and the mutual coupling of the coils via coupling factor "k". The band pass filter is tuned via input and output capacitors C1 and C2 which are connected across the coils, and the circuit is loaded by input and output conductance G1 and G2 again connected across the coils. Thus, the circuit input comprises a parallel input capacitor, input coil and input conductance, and the circuit output comprises a parallel output capacitor, output coil and output conductance.

Assuming $G = G1 = G2$; $C = C1 = C2$ and $L_t = L_{t1} = L_{t2}$ a useful (normalized) approximation (in the pass band area) of the complex transfer function is given by:

$$H(\Omega) = \frac{\sqrt{4 * F_1 - 1}}{2} \frac{j}{F_1 + j * \Omega - \Omega^2}$$

The parameter $\Omega$ is a normalised frequency and $F_1$ is a form factor, j represents $\sqrt{-1}$.

Figure 2 shows plots of $H(\Omega)$ for different form factor $F_1$ (ranging from 0.5 to 0.8). From this plot a desired characteristic can be chosen.

Taking into account a small ripple of about 0.3dB in the pass band, a useful form factor for band pass filter design is $F_1 = 0.6$

The form factor "$F_1$" is given by:

$$\frac{k}{d} = \sqrt{4 * F_1 - 1}$$

the variable "$d$" is the inverse quality factor of the resonant circuit, defined by:

$$d = \frac{G}{y_0}$$

wherein "$y_0$" is the characteristic admittance:

$$y_0 = \sqrt{\frac{C}{(1 - k^2) L_t}}$$

As a result, for a given form factor it is required

to design fixed $\dfrac{k}{d}$

The 3dB bandwidth of parameter $\Omega$ is also in fixed relation to the form factor, and defined by:

$$\Omega_{3dB} = \frac{\sqrt{-1 + \sqrt{9 - 4 * F_1} + 2 * F_1}}{\sqrt{2}}$$

For the normalised frequency the relation used is:

$$\Omega = \frac{v}{2 * d}$$

with detuning in relation to resonant frequency $f_0$ of:

$$v = \left(\frac{f}{f_0} - \frac{f_0}{f}\right)$$

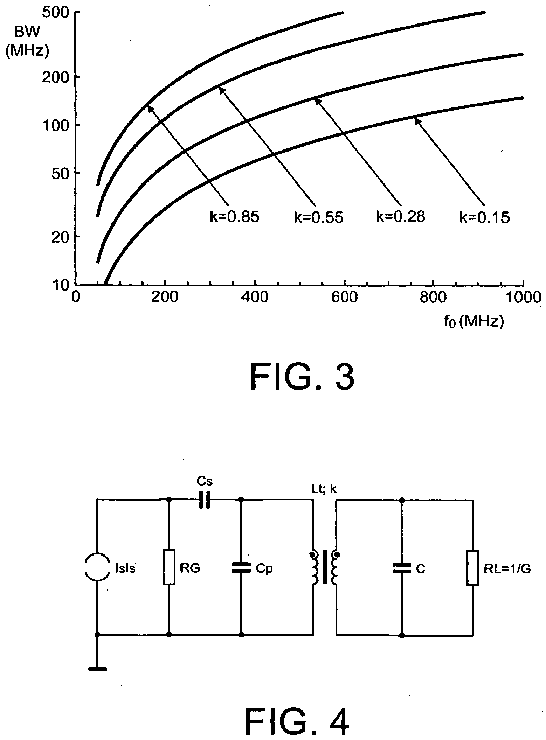

Taking into account the above relations, the 3dB bandwidth over frequency (versus parameter k) is shown by Figure 3, which shows the 3dB bandwidth for form factor F1=0.6 using different coupling coefficients "k".

Thus, taking into account the relationships described above, a required band pass characteristic can be designed by adjusting Lt, C and k of the arrangement in Figure 1.

The value of Lt can be set via the number of wiring turns and the wiring length, and the coupling k can be set via the coil distance and overlap of the magnetic field areas of the primary and secondary coils.

In addition to the definition of Lt, C and k, a matching network it is needed to complete the filter application. This is required, as for the use of the filter in radio receiver applications, the source termination "RG" needs to be matched to the load resistor RL.

The complete circuit is shown in Figure 4. The matching can be achieved by using suitable values of Cs and Cp :

$$C_s = \frac{1}{\omega_0 \sqrt{R_s \left(\frac{1}{G} - R_s\right)}}$$

$$C_p = C - \frac{1}{\omega_0 \sqrt{\dfrac{\frac{R_s}{G}}{1 - G * R_s}}}$$

Mutually coupled coils can be realized via discrete wire wound components in either SMD or leaded component technology. However, for cost reduction for ease of control over the electrical characteristics PCB based conductor patterns are used to form the coils.

The coupled coil structures described below are based on three different pattern types:

(i) The primary and secondary conductor loops alternate between top and bottom PCB layers using interconnection by vias. The axis of the magnetic coupling field is in the horizontal direction (parallel to the PCB surface).
(ii) A primary conductor loop is on the top layer and a secondary conductor loop is on the bottom layer. The axis of the magnetic coupling field is in the vertical direction (perpendicular to the PCB surface).
(iii) Both primary and secondary loops are on the same PCB layer. Magnetic coupling is then via parallel conductor tracks. The axis of the magnetic coupling field is in vertical direction (perpendicular to the PCB surface).

The examples below are based on the use of a Lt inductance target of about 250nH.

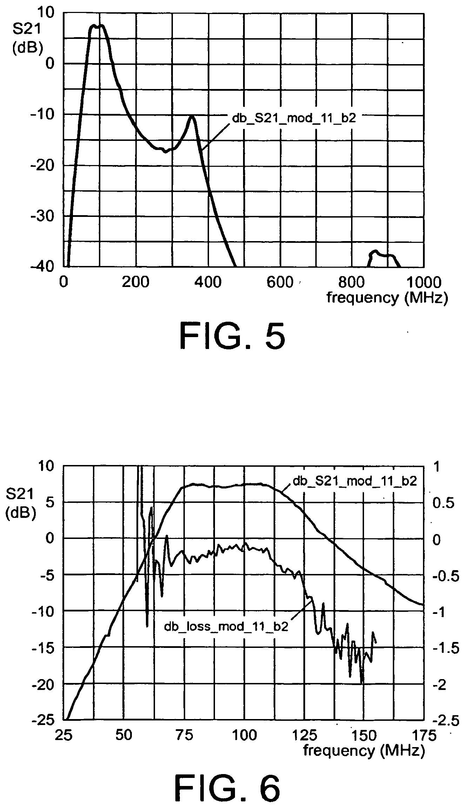

Results of a conventional FM radio VHFII band pass filter using a transformer are given in Figures 5 to 7 (i.e. with a high coupling coefficient obtained by a transformer device). The filter is designed by using a first coil of 290nH (high Q SMD coil), and a second coil based on a transformer device with input inductance of about 90nH and transformer ratio of about 1.42. The filter provides a pass band between 75MHz up to 110MHz.

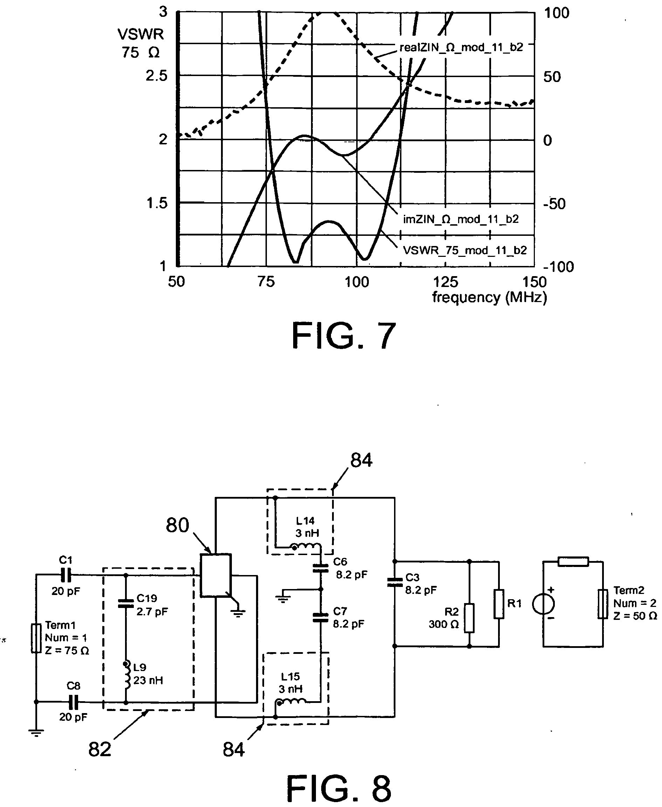

Figure 5 shows the frequency response as the S21 transmission loss value. Figure 6 shows the magnified S21 transmission loss response in the 25MHz to 175MHz range. Figure 7 shows the impedance matching performance in the 50MHz to 150MHz band.

Figure 8 shows the circuit using mutual coupled coils. The coupled coil arrangement is shown as 80. An input impedance matching branch is shown as 82 and additional small coils are shown as 84 to provide a notch at around 900MHz.

The design is based on coupled coils realized by using a conductor pattern on printed circuit boards.

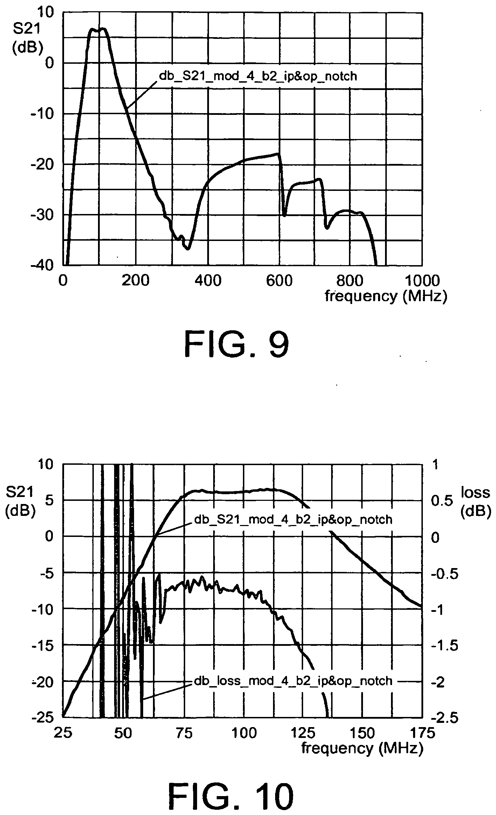

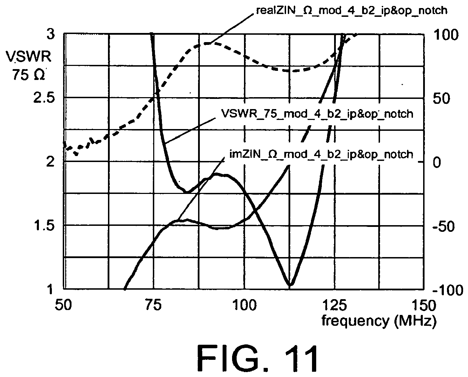

Graphs corresponding to Figures 5 to 7 are shown as Figures 9 to 11 for the circuit of Figure 8.

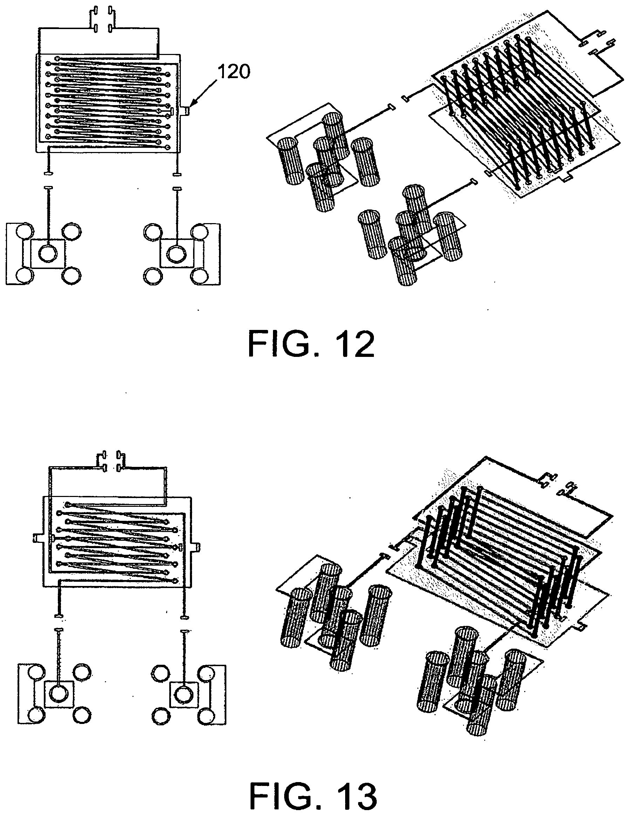

The mutually coupled PCB based coil arrangement used in the circuit of Figure 8 is shown in Figure 12.

Each coil comprises a first set of parallel tracks on one side and a second set of parallel tracks on the other side of a double sided printed circuit board, with through vias making connections to form a continuous coil. The parallel tracks of one coil are interleaved with the parallel tracks of the other coil, with the interleaving at each turn of the coils. This, the turns alternate between the two coils. This provides an interleaved coil design, with the shared magnetic field parallel to the PCB. The potential interfering fields from adjacent tracks are perpendicular to the PCB surface, so that the structure is less sensitive to unwanted signal coupling.

This example of the pattern provides input Lt of 235nH and output Lt of 220nH, the coupling k is 0.408. Due to the wiring spin, which alternates between top and bottom layer, the main magnetic field between the coils is in parallel to the PCB surface (horizontal field direction). This wiring implementation is used to achieve some isolation between coupled coils and signal tracks. For adjacent signal tracks the magnetic field is in vertical direction at PCB surface (perpendicular to PCB surface).

The load connected to the symmetrical output of the secondary coil is part of the receiver electronics. It is of advantage for some electronics to provide a ground reference via a center tap at the secondary coil. For this purpose, some examples use a tap at the secondary coil, for example as shown as 120 in Figure 12, and as shown in other examples below.

The design can be complemented by small coils (22nH at input and 3nH at output) realized via a small conductor pattern on the PCB. These coils perform series resonant circuits in conjunction with the corresponding input matching capacitance and output capacitance. This leads to notches in the overall filter transfer characteristic at 600MHz and 900MHz. These additional coils are independent from the coupled coil arrangement. These notches are used to improve the stop band attenuation at high frequencies. This improvement is required as the used coupled coil structure of Figure 12 is weak in high frequency stop band attenuation (and common mode rejection).

The test results of Figures 9 to 11 show a pass band in accordance with the FM VHFII band definition and input impedance in line with expectations and low implementation losses of about 0.7dB.

Figure 13 shows a similar design with fewer interleaved coils and a wider conductor distance in order to reduce parasitic capacitances.

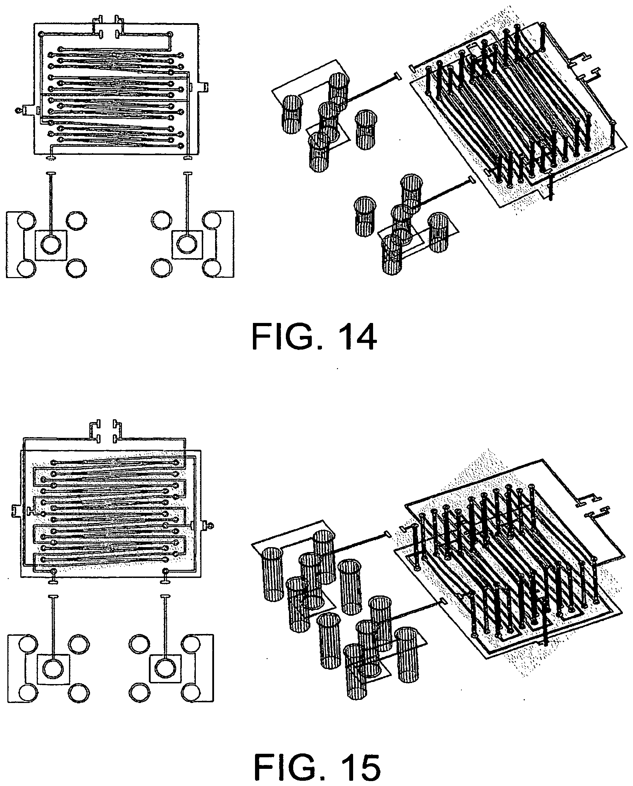

Figure 14 shows an arrangement in which each coil comprises a first set of parallel tracks on one side and a second set of parallel tracks on the other side, with through vias making connections to form a continuous coil. The coils are aligned with one next to the other along the coil axis direction. In this case, instead of the turns of one coil being interleaved with the turns of another, one coil is formed and placed next to another. There can be just two coils, one next to each other. However, in Figure 14, each coil comprises two sub-coils. Thus, there are four sub-coils, which alternate along the coil axis direction. Each coil comprises the two sub-coils in series, wherein a line of sub-coils is formed, alternating between sub-coils of one coil and sub-coils of the other coil. Thus, instead of alternating individual turns between the two coils, this design can be considered to interleave multiple turns of one coil with multiple turns of the other. The multiple turns each can be considered to be a sub-coil.

Figure 14 has sub-coils of 4 turns, then 3.5 turns then 3.5 turns then 4 turns (i.e. 7.5 turns altogether for the input coil and 7.5 turns altogether for the output coil).

Figure 15 shows an arrangement in which each coils has 4 sub-coils, each sub-coil with two turns, again with the sub-coils alternated. This design can be considered to have interleaving of pairs of turns rather than interleaving of individual turns as in the example of Figure 12.

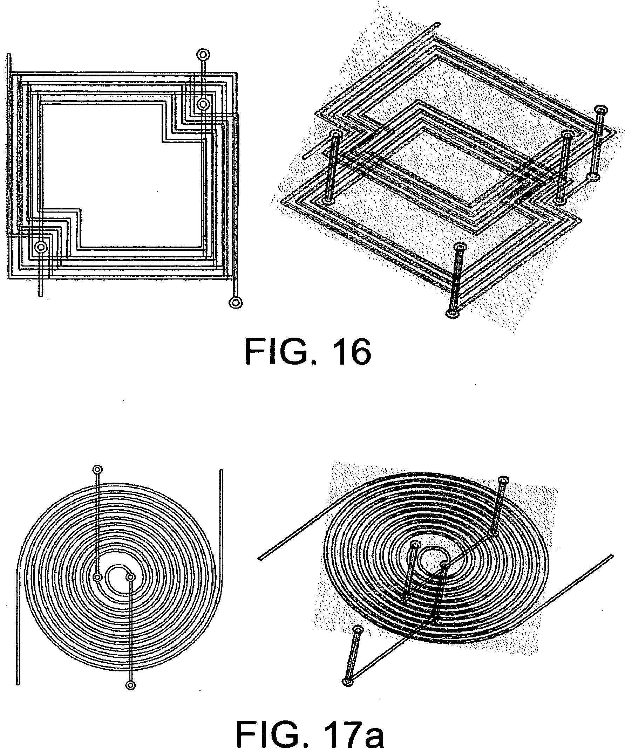

Figure 16 shows an example wherein each coil comprises a planar coil, with one coil formed on one side of the printed circuit board and the other coil formed on the other side of the printed circuit board. Each coil is a spiral (although with a generally square shape rather than a generally circular shape. The vias are used to make connections to the coil ends without tracks crossing.

Figure 17a shows an example wherein the coils comprise interleaved spirals formed on one side of the printed circuit board, with terminal connections to the central ends of the spirals formed on the other side of the printed circuit board. Each coil in this example is a spiral with a generally circular shape. The vias are again used to make connections to the coil ends without tracks crossing.

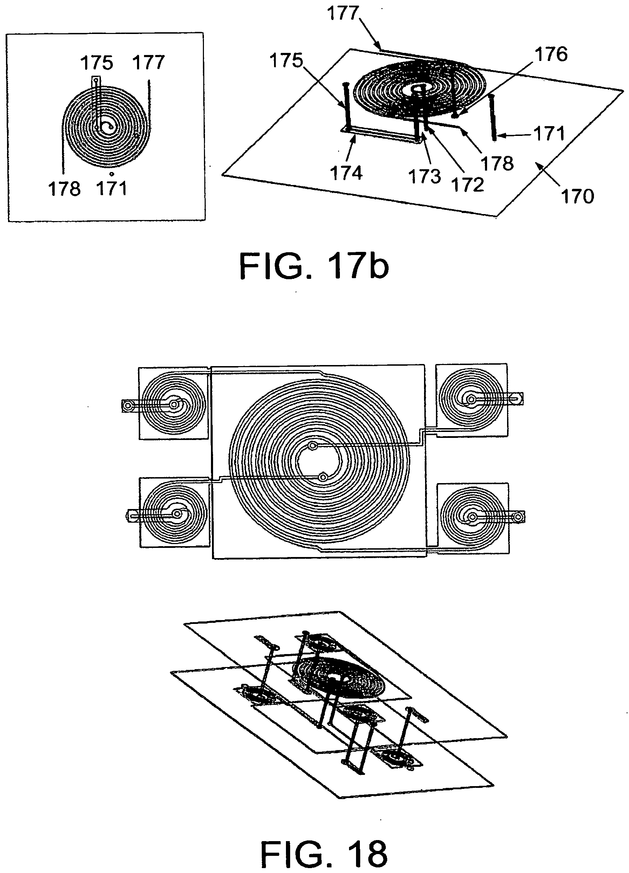

Figure 17b, shows a variation to Figure 17a, again using interleaved spirals. The advantage of the variation of Figure 17b is the placement of shielding ground on the other side of the printed circuit board. The shielding ground is shown as 170 in Figure 17b. The shielding protects the filter operation from possible interfering fields, but has only little effect on the magnetic coupling (about 6% reduction of coupling factor "k" from simulation results). The PCB typically has a thickenss of around 1.6mm which is large compared to the coil line spacing, for example of around 0.15mm.

In more detail, the design of Figure 17b has two interleaved coils on one side of the substrate. The primary coil ends at the very centre. Connection to this central end of the coil is by means of a via 171 which connects from the terminal (on the coil side of the PCB) down to the grond plane 170. The central end of the coil aslo connects to the ground plane by via 172, so that the ground plane provides a connection between the coil end and the terminal 171.

The central end of the secondary coils connects down to the opposite side of the PCB with via 173. A connecting track 174 is isolated from the ground plane (so that the ground plane has a slot) which then connects back up to the coil side of the PCB with via 175 which then defines the terminal for the inner end of the secondary coil.

A centre tap 176 is formed as a via for the secondary coil. This is also isolated from the ground plane (so the ground plane has an opening around ths via 176) so that the centre tap can be connected to ground through additional components.

The outer ends of the two coils terminate at terminals 177 and 178. All coil connections are thus on the coil side of the PCB.

As explained above, each coil can comprise one of the interleaved spiral coils and two further coils at the two ends of the interleaved spiral, to provide smaller input and output coils for reduction of the coupling factor k. This is shown in Figure 18.

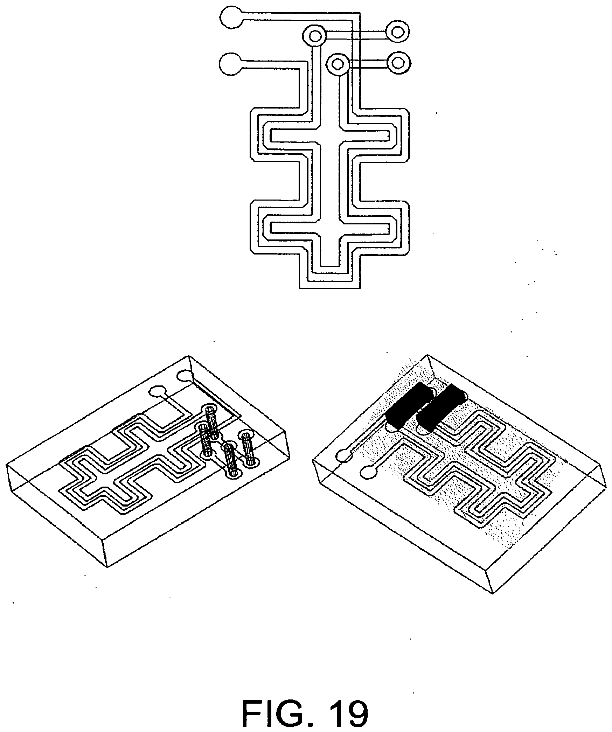

In Figure 19, each coil comprises a loop with one coil loop parallel to the other and both formed on one side of the printed circuit board. The output ports are connected by through vias and conductors on the opposite side of the PCB. The pattern can be formed on a "true" single layer using "zero Ohm" SMD components to bridge to the output ports, which is shown as an option in Figure 19.

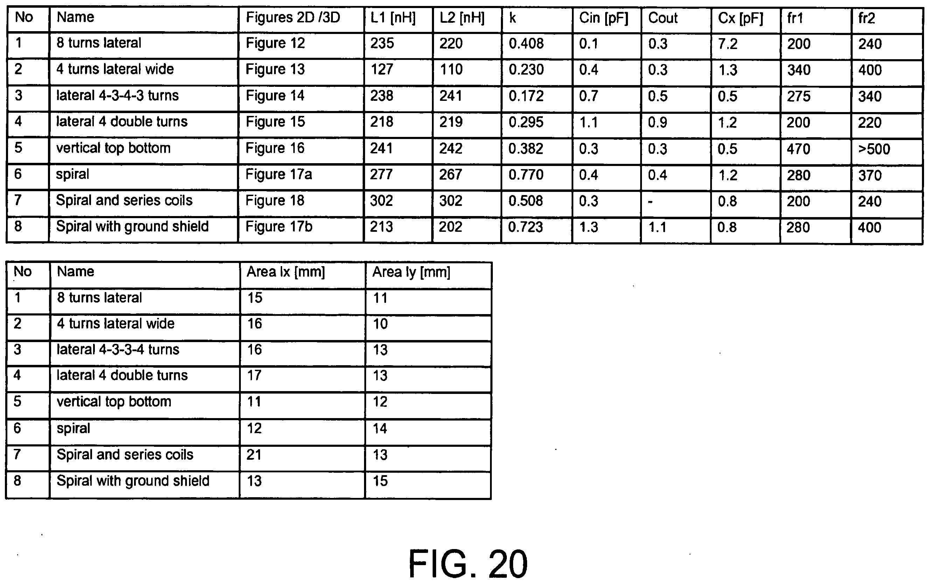

A summary of the some of the discussed design examples is given in the table of Figure 20.

In this table, L1 and L2 are the Lt inductances of input and output coils. k is the magnetic coupling factor between the primary and secondary coil. Cin / Cout /Cx are the parasitic input / output / transfer capacitances. fr1 and fr2 are resonances of the series connection of the primary and secondary coil in odd and even mode. These resonances are of interest, as despite the parasitic capacitances, there are additional capacitances distributed over the inductances. The more ideal the inductances are, the higher will be the resonance frequency.

Figure 20 shows that depending on the structure, there are specific optimal configurations for different uses:

> (i) for low parasitic capacitance and high resonance frequencies, design No 5 (vertical top bottom design of Figure 16);
> (ii) for high magnetic coupling k, design No 6 (spiral design of Figure 17);
> (iii) for good compromise in coupling and isolation against vertical magnetic field components for design No1 (lateral interleaved coils of Figure 12).

The examples above are based on double sided PCBs.

It is alternatively possible to provide similar or the same structures with multilayer PCBs. In this case, additional shielding structures can also be implemented to prevent unwanted signal coupling.

The same or similar structures can also be provided distributed over two PCBs, which are placed a narrow distance apart to capture sufficient mutual magnetic coupling.

Part of the inductance can be provided using PCB conductors as explained above, and part can be provided in-package by using bond wires, on-chip wires, or conductors for other package integration technologies. Thus, magnetic coupling between bond wires can be used as part of the inductive coupling. In this way, there is distribution of the inductor coil wiring between the PCB and the chip, using bond wires and PCB tracks.

The invention provides a band pass filter that can be used in receiver designs. For multi-tuner FM / DAB combinations it is possible to reduce the application effort by using switchable DAB / FM filters. Additionally it is possible to use a tuned band pass filter for DAB to improve rejection of the FM band via a first tuner (by keeping flexibility for DAB background scanning with a filter for the entire DAB band via a second tuner). This could be of benefit to avoid de-sensitization due to high FM signal levels, and to avoid DAB performance degradation due to intermodulation from FM band.

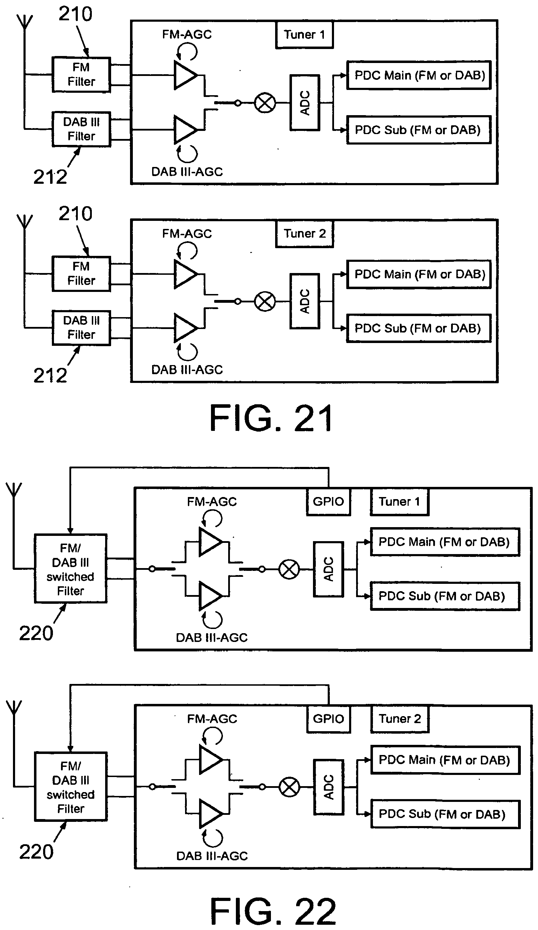

Various system configurations are shown in Figure 21 to Figure 24.

Figure 21 shows a two tuner arrangement with a straightforward input filter configuration. Each tuner has inputs for FM and DABIII. At the input, an FM filter 210 (approximately 80MHz to 110MHz) and a DAB filter 212 (approximately 170MHz to 250MHz) are provided. Overall, there are 2 FM filters and 2 DABIII filters and 4 RF inputs. Each tuner has a receiver circuit with a first band pass filter 210 for passing the FM radio band and which uses a first transformer device, and a second band pass filter 212 for passing the DAB III radio band and which uses a second transformer device.

It is possible to reduce the number of components by using a switchable band pass filter. In this case, two RF inputs can be saved, and the filter effort is reduced. This is shown in Figure 22, in which each of the two tuners has a switchable filter 220.

The frequency ranges for FM VHFII and DAB VHFIII are close together and for support of radio receiver electronics with limited pin count it is of value to feed the combined FM/DAB signal to a common input used either for FM radio at VHFII or DAB at VHFIII. This application requires a switched filter configuration, which either passes the FM band (and reduces the DAB band) or - even more important due to high unwanted signal level - passes the DAB band (and significantly reduces the FM band).

This switchable filter 220 can be realized in an economic way by using the mutual coupled coils as explained above.

The saving in one filter per tuner needs to be balanced with few additional switching diodes and a port for switch control.

The switchable band pass filter 220 at the input of each tuner is for switching between a first band pass mode passing the FM radio band and a second band pass mode passing the DAB III radio band.

Another option is the use of a tuned band pass filter for the specific DABIII channel. In this case the DAB input of the first tuner is based on a tuned BPF input, capable to provide FM band suppression of e.g. 45dB. FM band suppression in the range of 45dB avoids de-sensitization of the DAB signal in case of strong FM signals as well as intermodulation interference from FM to DABIII. The DABIII input of the second tuner is still based on a DAB band split filter. Therefore all required tuning actions - like DAB background scanning can be performed.

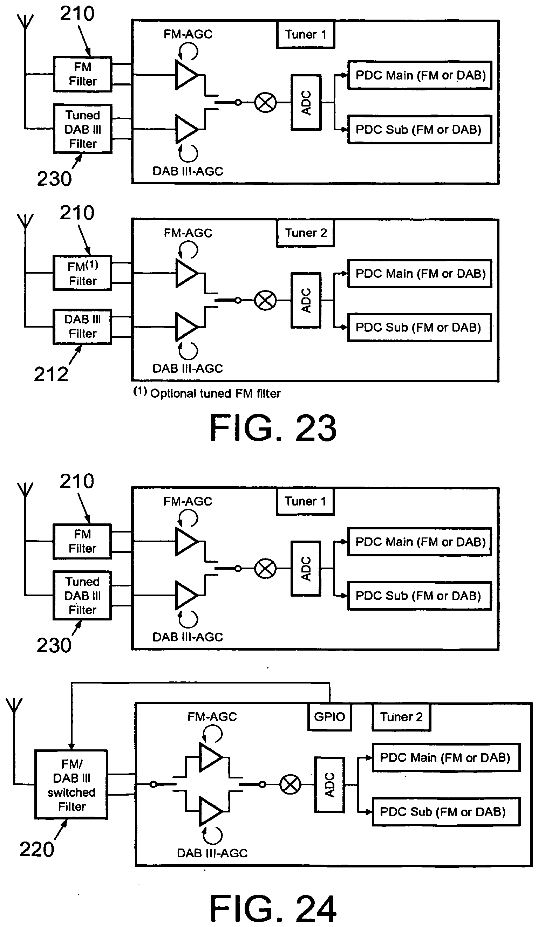

This example is shown in Figure 23, in which two different types of DAB filter are used. The narrower band DAB filter 230 is for a selected sub-band within the DAB III radio band. Thus, only a small part of the DABIII band is passed to the tuner, and this provides FM band suppression, for example of 45dB. A problem is the inability to receive a second DAB channel as a result of the small bandwidth.

It is thus also possible to combine both options - a switched band pass filter 220 and a tuned DAB filter 230. In this case the second tuner receives the FM or DABIII signals via a switched input filter 220, and the first tuner application is the combination of a FM band split filter 210 combined with DABIII tuned band pass filter 230. This arrangement is shown in Figure 24.

If the FM received signal in one tuner interferes with the broad band DAB reception in the other tuner, the receiver can be switched to the narrow band DAB mode, which provided better FM suppression. A tuned FM filter could also be used instead of a broad band receiver for the FM band.

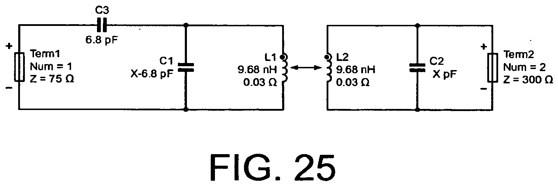

Figure 25 shows a circuit diagram for the tuned DAB band pass filter used in Figures 23 and 24, with approximately 10MHz band width.

For DAB reception it is desirable to have a very effective suppression of unwanted signal levels. A very good suppression of unwanted signal levels eases the receiver design in terms of linearity and AGC requirements and allows putting more focus on low noise behavior.

This design makes use of a tuned capacitor arrangement at the input and output sides, so that the input capacitance is X-6.8pF and the output capacitance is XpF as shown. The tuning frequency can be digital controlled.

By way of example, in order to perform the tuning of the band pass filter a switched capacitor bank can be used. For this purpose MIM capacitances in conjunction with PIN switching diodes (or alternatively by switching the MIM capacitors with MEMS switches) can be used.

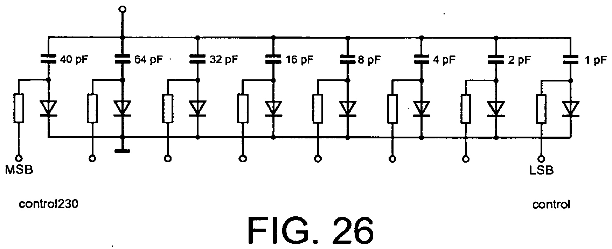

Figure 26 shows a basic switch capacitor configuration. As shown, MIM capacitors are connected to anodes of PIN switching diodes. The electrode area of the MIM capacitor is about the same area as the anode of the diode. The diodes are switched in conductive mode via current control. The control current is applied via resistors to the diode. The resistors are required to decouple the impedance of the switch control current source from the capacitor. The resistor decoupling is designed for minimum effect of the switch control to the switched capacitor function.

The equivalent circuit for a PIN switching diode in the "ON" state is a resistor. The value of the resistor depends on the value of the forward current. Typically the resistance decreases exponentially with increasing forward current. The equivalent circuit for PIN switching diode in "OFF" mode is a capacitor with series resistance.

The capacitance in "OFF" mode is a key parameter in order to design the size of the switched MIM capacitor bank. By way of example a BA277 diode provides an "OFF" capacitor at zero volts of about 1 pF.

To set the control to the maximum "OFF" capacitance all diodes of the bank are in the "OFF" mode. The "OFF" capacitance is part of the BPF tuning capacitor, and this capacitance is provided in conjunction with lowest resistance value of the equivalent "OFF" mode series resistor.

Because of the smaller bandwidth of the tuned DAB band pass filter the coupled coil design requires low values for the coupling, for example k=0.049 in this example, and a low value for the inductance of Lt=9.68 nH only. These small coil design values can enable compact designs, and furthermore the digital controlled tuning capacitor can be extended to support dual tuned DAB filters, which in addition reduces significantly the overall filter design effort. Because of the low Lt and k values a PCB based structure will occupy a small area only.

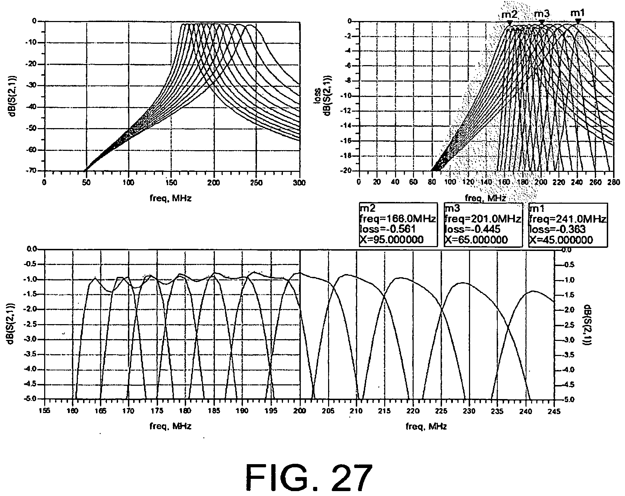

Figure 27 show the simulation results. The top left plot shows the S21 transmission loss value, and the top right plot shows the implementation loss of the filter, which is defined by:

$$loss = 20 * \log_{10} \sqrt{\frac{(abs(S21))^2}{1 - (abs(S11))^2}}$$

The bottom plot is an enlarged part of the region of interest of the top left S21 plot.

A step size for parameter "X" of 5pF is just used between the different curves plotted, and the tuning capacitor is stepped from 45pF to 95pF. Lower values of X give rise to higher frequencies. It is of course possible to fit the step size to given requirements.

The tuned BPF design gives a reduction of the entire FM band of better than 45dB for lowest tuning point and better than 52dB for the highest tuning point.

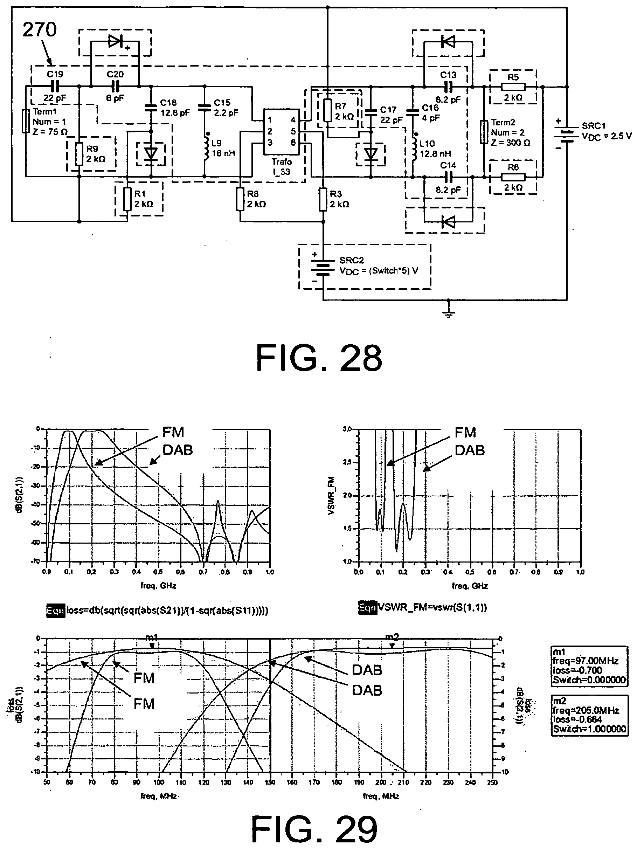

Figure 28 shows a schematic design example (for simulation) of a GPIO (general purpose input/output) controlled switched FM VHFII / DAB VHFIII band pass filter as used in Figures 22 and 24.

The switch control elements and RF switching diodes used to implement the switching function are shown circled with dotted lines.

The filter elements are shown as group 270. Details are described below.

The mutual coupled coil has input and output center taps for switch control DC feeding. This center tap is used at each primary and secondary part of the coupled coil arrangement. This additional tap is needed for DC insertion only. The DC is passed via the coil wiring to the switching diodes - which are connected to the mutual coupled coil arrangement - for switch control.

In this example the coil inductance Lt=130nH and K=0.39. Due to the lower required Lt (130nH instead of 230nH as used in the example above) a PCB design of coupled coils is less demanding.

For switching on the FM VHF II pass band mode, the switch control voltage SRC2 is set to 0V. In this mode all RF switching diodes are in conducting mode, which can be seen in a simplified way as a short. In this mode the sum capacitance of capacitors C15, C18, C19 are performing the input resonance mode and the sum capacitance of capacitors C16, C17 are performing the output resonance mode.

For switching on the DAB VHFIII band pass filter mode the switch control voltage SRC2 is set to 5V In this mode all RF switching diodes are in isolation mode, which can be seen in a simplified way as an open circuit. In this mode the sum capacitance of capacitors C20 (shared by C19), C15 are performing the input resonance mode and the sum capacitance of capacitors C16, and half value of C13,C14 are performing the output resonance mode.

For improvement of the stop band isolation the capacitor C15 is extended by a series resonant coil L9 (which can be realized by appropriate PCB conductor pattern), and performs a notch at about 850MHz, and the capacitor C16 is extended by a series resonant coil L10, and performs a notch at about 700MHz. By using these notch filters, the stop band attenuation can be improved by >6dB at >400MHz and >12dB at >500MHz.

The source impedance is matched to the load impedance in case of FM VHF II via C19 and in case of DAB VHFIII the load resistor is up transformed via C13 and C14, and the source impedance is matched to the up-transformed load resistor by using C20 (shared by C19).

Figure 29 shows simulation results for this circuit, and shows in the top left the S21 transmission loss, in the top right the VSWR function and the S21 loss in the 50MHz to 250MHz range in the bottom plot. The two curves in each plot relate to the two switch positions, for FM and for DAB. The bottom plot also shows the parameter "loss". This parameter is the implementation loss of the filter, which is defined by:

$$loss = 20 * \log_{10}\sqrt{\frac{(abs(S21))^2}{1 - (abs(S11))^2}}$$

Depending on the level of inductance and mutual coupling factor it may also be possible to combine the filter function by integration in one package.

The invention can also be used for scanning antenna diversity.

The purpose of scanning antenna diversity is to perform a combination of two antenna signals (a first antenna signal "A" and a second antenna signal "B") controlled by the FM radio broadcast receiver. By this switching the quality of FM radio reception can be improved. In such application there are in general four different signal combinations controlled by a RF switch circuit. These combinations are (a) antenna signal "A" only; (b) antenna signal "B" only; (c) sum of signals "A" and "B"; and (d) difference of signals "A" and "B".

Modes "a" to "c" are performed by switching. However the mode "d" requires signal inversion before switching. Thus, a building block for a "scanning antenna diversity" application is a signal inverter, in the form of a passive 180 degree RF signal inverter.

On the basis of a PCB coil structure, providing high mutual coupling, it is possible to perform this passive 180 degree RF signal inverter in an economic way.

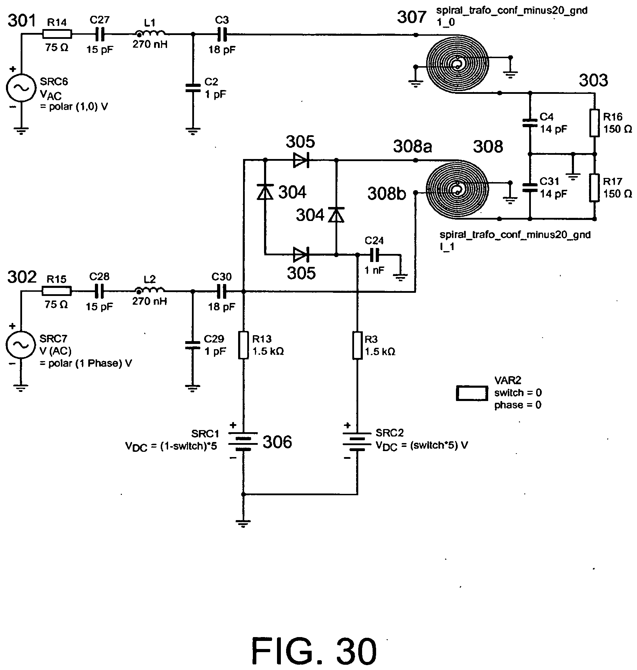

Figure 30 shows a circuit, which is able to support the modes (c) sum of signals "A" and "B"; and (d) difference of signals "A" and "B".

This circuit makes use of the structure "No 8" from the table of Figure 20.

The two antenna signal equivalents are shown as 301 and 302.

The signal 301 is passed via a PCB coil structure 307 to the receiver input 303, shown as equivalent termination resistors. The signal 302 is passed via a signal commuter - based on PIN switching diodes - to inputs 308a,308b of a PCB coil structure. The complementary operating switch control unit 306 - when operating in a first switching mode - sets diodes 305 in conductive mode and diodes 304 in reverse mode or vice versa when operating in a second switching mode.

As a result of the switching, the antenna signal 302 is either passed to 308a and the signal ground is passed to 308b, or vice versa. Consequently the output of the second PCB coil structure 308 is either in phase or in opposite phase to the first PCB coil structure 307, depending of the switching.

As the output of the two coil structures 307 and 308 are operating in differential mode, the voltage at the receiver input 303 is either the sum or the difference of the processed signals 301 and 302. The receiver input circuit 303 can thus be considered to be a combining circuit.

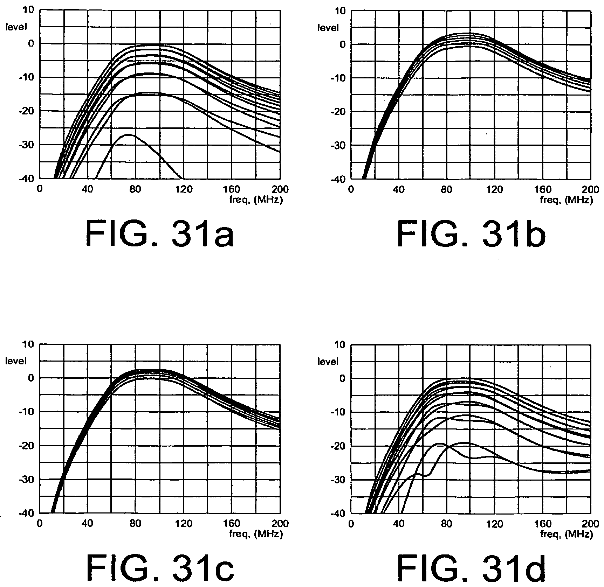

The advantage of this configuration is shown in Figure 31

Figure 31 a shows switch position "0" with phase difference from -90 degrees to +90 degrees in 15 degree steps. Figure 31b shows switch position "1" with phase difference from -90 degrees to +90 degrees in 15 degree steps. Figure 31c shows switch position "0" with phase difference from +90 degrees to +270 degrees in 15 degree steps. Figure 31d shows switch position "1" with phase difference from +90 degrees to +270 degrees in 15 degree steps.

For a test case of Figure 31 and Figure 31b both antenna signals 301 and 302 are assumed to be equal in level, but the phase relation is stepped between positive and negative 90 degrees (in 15degree steps per simulation frequency sweep). The poor transmission response (due to signal cancellation) of Figure 31 a can be improved with appropriate switch control of switching unit 306 as demonstrated in Figure 31 b. When for a second test case of Figure 31c and Figure 31d the phase variation starts at 90 degrees and ends up at 270 degrees, then the opposite switch position improves the overall response as shown in Figure 31 c.

As a result, a radio channel cancellation via two antennas is blocked by this circuit configuration.

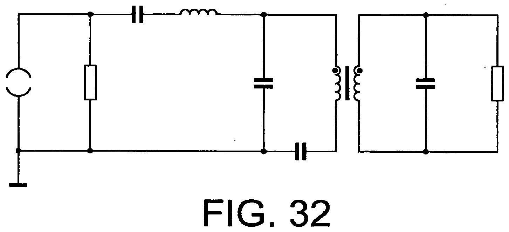

The basic structure of known filter designs for band pass filtering for an in-car broadcast receiver applications is shown in Figure 32. The band pass filter circuit comprises an LC circuit at the input to the transformer, having a series inductor and capacitor branch and a parallel capacitor branch. A parallel capacitor is at the output of the transformer.

Based on this known circuit configuration it is possible to use the structure "No 8" from the table of Fig. 20.

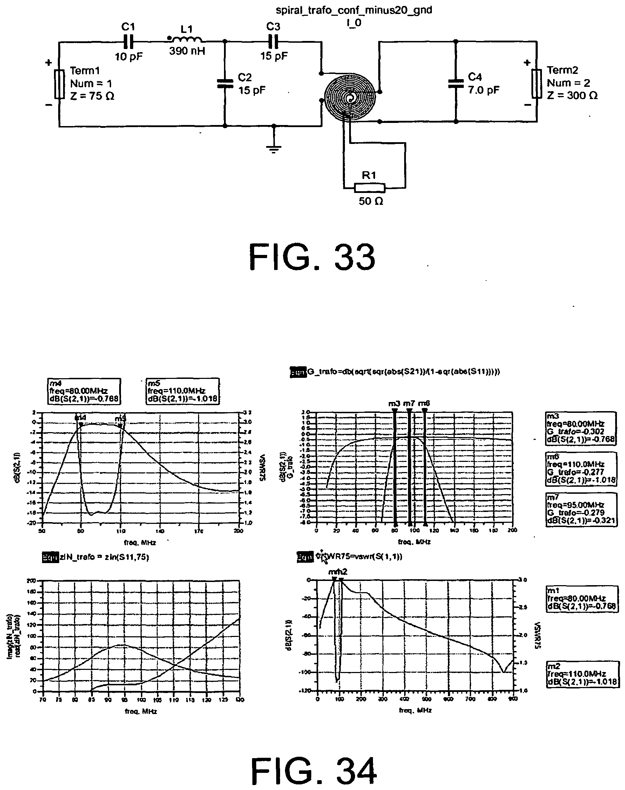

Figure 33 shows this implementation using a SMD coil in conjunction with the mutual coupled coils from Figure 17b and Figure 34 shows the performance of the alternative filter implementation of Figure 33. A special benefit of this design example is the shielding ground provided with this interleaved spiral inductor configuration, which protects the filter implementation from possible interfering fields.

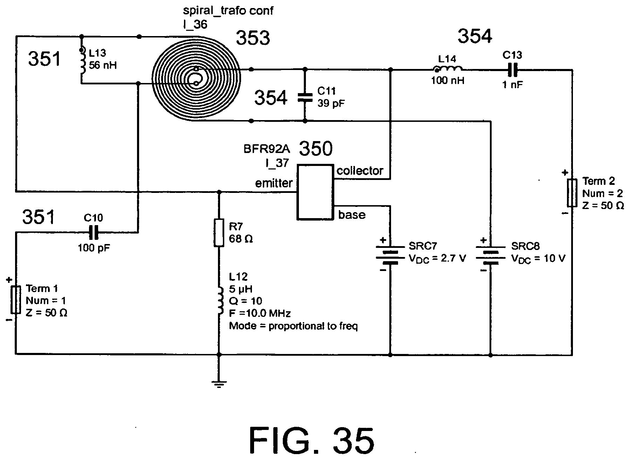

Figure 35 shows another filter circuit variation comprising the combination of a mutual coupled coil with an active component, which provides small gain in the pass band frequency range.

The mutual coupled coils from Figure 17a is shown as 353, and a bipolar NPN RF transistor is shown as 350, which operates in common base mode using an operating current of about 19mA.

In this configuration the mutual coupled coil 353 is used for signal degeneration of the common base transistor stage 350.

The input filter function is supported by the UC components 351 and the output filter function is supported by the components 354. Values are tuned to pass the FM VHFII band. The gain is set to 6.5dB

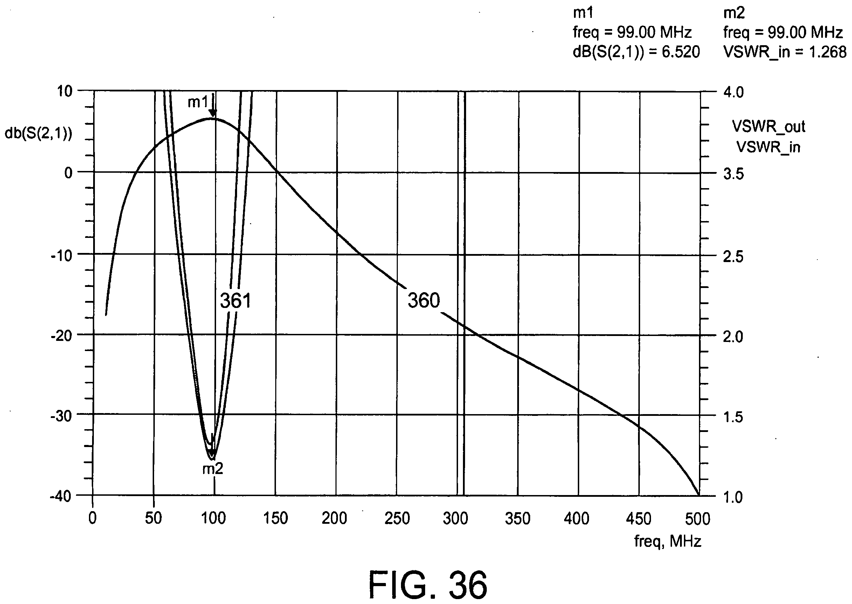

Figure 36 shows performance measurements. The curve 360 shows the frequency response as the S21 transmission loss value, providing a peak gain of 6.5dB and curve 361 shows the VSWR response at input and output terminals, providing a matching better than VSWR of 2 within the FM VHFII frequency band

The invention thus enables mutual coupled coils to be used to:

- interface active or passive antenna systems to car radio broadcast receiver electronics
- perform band pass filter characteristics to pass a wanted frequency band (e.g. VHF II band for FM radio reception) and to suppress unwanted frequency band (e.g. suppression of unwanted LW/AM/SW band and unwanted DAB VHF III band against wanted VHF II band for FM radio).
- perform impedance matching between antenna application and receiver input and by appropriate coils / capacitors combination
- perform single ended input to symmetrical output conversion, because of the mutual coupled coil physics, which provides differential signal output at the secondary (output) coil

The design of the mutual coupled coils can be implemented by an appropriate conductor pattern, on a printed circuit board or boards.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

**Claims**

1. A radio broadcast receiver, comprising an electric circuit having at least one transformer device forming part of a band pass filter circuit (210, 212, 220, 230), wherein the at least one transformer device comprises a pair of mutually coupled inductor coils formed as printed circuit board tracks,
   **characterized in that** the coils comprise interleaved spirals formed on one side of the printed circuit board, with terminal connections to central ends of the spirals formed using connections on the other side of the printed circuit board,
   wherein each coil comprises one of the interleaved spiral coils and two further coils at the two ends of the interleaved spiral.

2. A radio broadcast receiver as claimed in claim 1, wherein the inductor coils are formed as tracks on both sides of a double-sided printed circuit board, and each coil comprises:

   a first set of parallel tracks on one side and a second set of parallel tracks on the other side, with through vias making connections to form a continuous coil, wherein the parallel tracks of one coil are interleaved with the parallel tracks of the other coil; or
   a planar coil, with one coil formed on one side of the printed circuit board and the other coil formed on the other side of the printed circuit board.

3. A radio broadcast receiver as claimed in claim 1, wherein the inductor coils are formed as tracks on both sides of a double-sided printed circuit board, and wherein each coil comprises a first set of parallel tracks on one side and a second set of parallel tracks on the other side, with through vias making connections to form a continuous coil, wherein the coils are aligned with one next to the other.

4. A radio broadcast receiver as claimed in claim 3, wherein each coil comprises at least two sub-coils in series, wherein a line of sub-coils is formed, alternating between sub-coils of one coil and sub-coils of the other coil.

5. A radio broadcast receiver as claimed in claim 1, wherein a ground plane is provided on the opposite side of the printed circuit board to the coils.

6. A radio broadcast receiver as claimed in claim 1, wherein each coil comprises a loop with one coil loop parallel to the other and both formed on one side of the printed circuit board.

7. A radio broadcast receiver as claimed in any preceding claim, comprising a capacitor bank circuit for tuning the band pass filter circuit (210, 212, 220, 230), wherein the capacitor bank comprises MIM capacitors and PIN diodes.

8. A radio broadcast receiver as claimed in any preceding claim, comprising a first and second antenna, a switching arrangement and a combining circuit which is adapted to generate a sum signal or a difference signal from the two antenna signals based on the switching arrangement configuration, wherein the signal from the first antenna is passed via the pair of mutually coupled inductor coils formed as printed circuit board tracks to the combining circuit and the signal from the second antenna is passed via the switching arrangement to the combining circuit.

9. A radio broadcast receiver as claimed in any preceding claim, wherein the band pass filter circuit (210, 212, 220, 230) comprises an LC circuit at the input to the transformer device, having a series inductor and capacitor branch and a parallel capacitor branch, and a parallel capacitor at the output of the transformer device.

10. A radio broadcast receiver as claimed in any preceding claim, comprising a first band pass filter circuit (210, 212, 220, 230) as defined in claim 1 for passing an FM radio band and which uses a first transformer device as defined in claim 1, and a second band pass filter circuit (210, 212, 220, 230) as defined in claim 1 for passing an DAB III radio band and which uses a second transformer device as defined in claim 1.

11. A radio broadcast receiver as claimed in any one of claims 1 to 10, comprising a switchable band pass filter circuit (210, 212, 220, 230) as defined in claim 1 for switching between a first band pass mode passing the FM radio band and a second band pass mode passing the DAB III radio band.

12. A radio broadcast receiver comprising two tuners, a first tuner having a radio broadcast receiver as claimed in claim 10, and a second tuner which comprises a first band pass filter circuit (210, 212, 220, 230) as defined in claim 1 for passing the FM radio band and which uses a first transformer device as defined in claim 1, and a second band pass filter circuit (210, 212, 220, 230) as defined in claim 1 for passing a selected sub-band within the DAB III radio band and which uses a second transformer device as defined in claim 1.

13. A radio broadcast receiver comprising two tuners, a first tuner having a radio broadcast receiver as claimed in claim 11, and a second tuner which comprises a first band pass filter for passing the FM radio band and which uses a first transformer device as defined in claim 1, and a second band pass filter for passing a selected sub-band within the DAB III radio band and which uses a second transformer device as defined in claim 1.

**Patentansprüche**

1. Ein Radioübertragung Empfänger aufweisend einen elektrischen Schaltkreis, der wenigstens eine Transformator Vorrichtung hat, die einen Teil eines Bandpassfilter Schaltkreises (210, 212, 220, 230) bildet, wobei die wenigstens eine Transformator Vorrichtung ein Paar von gegenseitig gekoppelten Induktionsspulen aufweist, die als Leiterplattenspuren gebildet sind
   **dadurch gekennzeichnet, dass** die Spulen verschachtelte Spiralen aufweisen, die gebildet sind auf einer Seite der Leiterplatte mit terminalen Verbindungen zu zentralen Enden der Spiralen, die gebildet sind unter Verwenden von Verbindungen auf der anderen Seite der Leiterplatte,
   wobei jede Spule aufweist eine der verschachtelten Spiral Spulen und zwei weitere Spulen an den zwei Enden der verschachtelten Spirale.

2. Ein Radioübertragung Empfänger gemäß Anspruch 1, wobei die Induktionsspulen gebildet sind als Spuren auf beiden Seiten einer doppelseitigen Leiterplatte, und
   jede Spule aufweist:

   einen ersten Satz von parallelen Spuren auf einer Seite und einen zweiten Satz von parallelen Spuren auf der anderen Seite, mit Durchgang Vias, die Verbindungen herstellen, um eine kontinuierliche Spule zu bilden, wobei die parallelen Spuren von einer Spule verschachtelt sind mit den parallelen Spuren von der anderen Spule; oder

eine planare Spule, mit einer Spule, die gebildet ist auf einer Seite der Leiterplatte, und der anderen Spule, die gebildet ist auf der anderen Seite der Leiterplatte.

**3.** Ein Radioübertragung Empfänger gemäß Anspruch 1, wobei

die Induktionsspulen gebildet sind als Spuren auf beiden Seiten einer doppelseitigen Leiterplatte und wobei jede Spule aufweist einen ersten Satz von parallelen Spuren auf einer Seite und einen zweiten Satz von parallelen Spuren auf der anderen Seite, mit Durchgang Vias, die Verbindungen herstellen, um eine kontinuierliche Spule zu bilden, wobei die Spulen eine neben der anderen ausgerichtet sind.

**4.** Ein Radioübertragung Empfänger gemäß Anspruch 3, wobei jede Spule aufweist wenigstens zwei Subspulen in Serie, wobei eine Reihe von Subspulen gebildet ist, die alternieren zwischen Subspulen von einer Spule und Subspulen der anderen Spule.

**5.** Ein Radioübertragung Empfänger gemäß Anspruch 1, wobei eine Erdungsebene bereitgestellt ist auf unterschiedlichen Seiten der Leiterplatte zu den Spulen.

**6.** Ein Radioübertragung Empfänger gemäß Anspruch 1, wobei jede Spule aufweist eine Schleife mit einer Spulenschleife parallel zu der anderen und beide gebildet sind auf einer Seite der Leiterplatte.

**7.** Ein Radioübertragung Empfänger gemäß einem der vorhergehenden Ansprüche, aufweisend

einen Kondensatorbank Schaltkreis zum Feineinstellen des Bandpassfilter Schaltkreises (210, 212 , 220, 230), wobei die Kondensatorbank MIM Kondensatoren und PIN Dioden aufweist.

**8.** Ein Radioübertragung Empfänger gemäß einem der vorhergehenden Ansprüche, aufweisend

eine erste und zweite Antenne, eine Schaltanordnung und einen kombinierenden Schaltkreis, der ausgestaltet ist zu erzeugen ein Summensignal oder einen Differenzsignal von den beiden Antennensignalen basierend auf der Schaltanordnung Konfiguration, wobei

das Signal von der ersten Antenne weitergeleitet wird über das Paar von gegenseitig gekoppelten Induktionsspulen, die gebildet sind als Leiterplattenspuren, zu dem kombinierenden Schaltkreis und

das Signal von der zweiten Antenne weitergeleitet wird über die Schaltanordnung zu dem kombinierenden Schaltkreis.

**9.** Ein Radioübertragung Empfänger gemäß einem der vorhergehenden Ansprüche, wobei der Bandpassfilter Schaltkreis (210, 212, 220, 230) aufweist einen LC Schaltkreis an dem Eingang zu der Transformator Vorrichtung, der einen Reihen Induktor und Kondensator Zweig und einen parallelen Kondensator Zweig hat, und einen parallelen Kondensator Zweig an dem Ausgang von der Transformator Vorrichtung.

**10.** Ein Radioübertragung Empfänger gemäß einem der vorhergehenden Ansprüche, aufweisend

einen ersten Bandpassfilter Schaltkreis (210, 212, 220, 230), wie in Anspruch 1 definiert, zum Weiterleiten eines FM Radiobandes, und welcher eine erste Transformator Vorrichtung verwendet, wie in Anspruch 1 definiert, und

einen zweiten Bandpassfilter Schaltkreis (210, 212, 220, 230), wie in Anspruch 1 definiert, zum Weiterleiten eines DAB III Radiobandes, und welcher eine zweite Transformator Vorrichtung verwendet, wie in Anspruch 1 definiert.

**11.** Ein Radioübertragung Empfänger gemäß einem der vorhergehenden Ansprüche 1 bis 10, aufweisend einen schaltbaren Bandpassfilter Schaltkreis (210, 212, 220, 230), wie in Anspruch 1 definiert, zum Schalten zwischen einem ersten Bandpass Zustand, der das RM Radioband weiterleitet, und einem zweiten Bandpass Zustand, der das DAB III Radioband weiterleitet.

**12.** Ein Radioübertragung Empfänger aufweisend zwei Tuner,

einen ersten Tuner, der einen Radioübertragung Empfänger gemäß Anspruch 10 hat, und einen zweiten Tuner, der einen ersten Bandpassfilter Schaltkreis (210, 212, 220, 230) aufweist, wie in Anspruch 1 definiert, zum Weiterleiten des FM Radiobandes und welcher eine erste Transformator Vorrichtung verwendet, wie in Anspruch 1 definiert, und einen zweiten Bandpassfilter Schaltkreis (210, 212, 220, 230) aufweist, wie in Anspruch 1 definiert, zum Weiterleiten eines Subbandes innerhalb des DAB III Radiobandes und welcher eine zweite Transformator Vorrichtung verwendet, wie in Anspruch 1 definiert.

**13.** Ein Radioübertragung Empfänger aufweisend zwei Tuner,

einen ersten Tuner, der einen Radioübertragung Empfänger hat, gemäß Anspruch 11 und einen zweiten Tuner, der einen ersten Bandpassfilter aufweist zum Weiterleiten des FM Radiobandes, und welcher verwendet eine erste Transformator Vorrichtung, wie in Anspruch 1 definiert, und einen zweiten Bandpassfilter zum Weiterleiten eines ausgewählten Subbandes innerhalb des DAB III Radiobandes und welcher eine zweite Transformator Vorrichtung verwendet, wie in Anspruch 1 definiert.

## Revendications

1. Récepteur de radiodiffusion, comprenant un circuit électrique comportant au moins un dispositif transformateur faisant partie d'un circuit à filtres passe-bande (210, 212, 220, 230), l'au moins un dispositif transformateur comprenant une paire de bobines d'inductance couplées mutuellement prenant la forme de traces d'une plaquette de circuit imprimé, le récepteur de radiodiffusion étant **caractérisé en ce que** les bobines comprennent des spirales entrelacées formées sur une face de la plaquette de circuit imprimé, des connexions de bornes avec des extrémités centrales des spirales étant formées au moyen de connexions sur l'autre face de la plaquette de circuit imprimé, chaque bobine comprenant l'une des bobines à spirales entrelacées et deux autres bobines aux deux extrémités de la spirale entrelacée.

2. Récepteur de radiodiffusion selon la revendication 1, les bobines d'inductance prenant la forme de traces sur les deux faces d'une plaquette de circuit imprimé double face, et chaque bobine comprenant :

   un premier jeu de traces parallèles sur une face et un deuxième jeu de traces parallèles sur l'autre face, des vias traversants réalisant des connexions pour former une bobine continue, les traces parallèles d'une bobine étant entrelacées avec les traces parallèles de l'autre bobine ; ou
   une bobine plane, une bobine étant formée sur une face de la plaquette de circuit imprimé et l'autre bobine étant formée sur l'autre face de la plaquette de circuit imprimé.

3. Récepteur de radiodiffusion selon la revendication 1, les bobines d'inductance prenant la forme de traces sur les deux faces d'une plaquette de circuit imprimé double face, et chaque bobine comprenant un premier jeu de traces parallèles sur une face et un deuxième jeu de traces parallèles sur l'autre face, des vias traversants réalisant des connexions pour former une bobine continue, les bobines étant alignées l'une à côté de l'autre.

4. Récepteur de radiodiffusion selon la revendication 3, chaque bobine comprenant au moins deux sous-bobines en série, une ligne de sous-bobines étant formée par alternance entre des sous-bobines d'une bobine et des sous-bobines de l'autre bobine.

5. Récepteur de radiodiffusion selon la revendication 1, un plan de sol étant prévu sur la face de la plaquette de circuit imprimé opposée aux bobines.

6. Récepteur de radiodiffusion selon la revendication 1, chaque bobine comprenant une boucle, une boucle de bobine étant parallèle à l'autre et les deux étant formées sur une face de la plaquette de circuit imprimé.

7. Récepteur de radiodiffusion selon l'une quelconque des revendications précédentes, comprenant un circuit à batterie de condensateurs destiné à accorder le circuit à filtres passe-bande (210, 212, 220, 230), la batterie de condensateurs comprenant des condensateurs MIM et des diodes PIN.

8. Récepteur de radiodiffusion selon l'une quelconque des revendications précédentes, comprenant une première et une deuxième antenne, un montage de commutation et un circuits combineur adapté à générer un signal somme ou un signal différence à partir des deux signaux d'antenne en fonction de la configuration du montage de commutation, le signal provenant de la première antenne passant au circuit combineur par le biais de la paire de bobines d'inductance couplées mutuellement prenant la forme de traces de la plaquette de circuit imprimé, et le signal provenant de la deuxième antenne passant au circuit combineur par le biais du montage de commutation.

9. Récepteur de radiodiffusion selon l'une quelconque des revendications précédentes, le circuit à filtres passe-bande (210, 212, 220, 230) comprenant un circuit LC à l'entrée du dispositif transformateur, comportant une branche à inductance et condensateur en série et une branche à condensateur en parallèle, et un condensateur en parallèle à la sortie du dispositif transformateur.

10. Récepteur de radiodiffusion selon l'une quelconque des revendications précédentes, comprenant un premier circuit à filtres passe-bande (210, 212, 220, 230) selon la revendication 1 destiné à laisser passer une bande radio FM et utilisant un premier dispositif transformateur selon la revendication 1, et un deuxième circuit à filtres passe-bande (210, 212, 220, 230) selon la revendication 1 destiné à laisser passer une bande radio DAB III et utilisant un deuxième dispositif transformateur selon la revendication 1.

11. Récepteur de radiodiffusion selon l'une quelconque des revendications 1 à 10, comprenant un circuit à filtres passe-bande commutable (210, 212, 220, 230) selon la revendication 1 destiné à commuter entre un premier mode passe-bande laissant passer la bande radio FM et un deuxième mode passe-bande laissant passer la bande radio DAB III.

12. Récepteur de radiodiffusion comprenant deux blocs d'accord, un premier bloc d'accord comportant un récepteur de radiodiffusion selon la revendication 10, et un deuxième bloc d'accord comprenant un premier circuit à filtres passe-bande (210, 212, 220, 230) selon la revendication 1 destiné à laisser passer la bande radio FM et utilisant un premier dispositif transformateur selon la revendication 1, et un deuxième circuit à filtres passe-bande (210, 212, 220, 230) selon la revendication 1 destiné à laisser passer une sous-bande sélectionnée au sein de la bande radio DAB III et utilisant un deuxième dispositif transformateur selon la revendication 1.

13. Récepteur de radiodiffusion comprenant deux blocs d'accord, un premier bloc d'accord comportant un récepteur de radiodiffusion selon la revendication 11, et un deuxième bloc d'accord comprenant un premier filtre passe-bande destiné à laisser passer la bande radio FM et utilisant un premier dispositif transformateur selon la revendication 1, et un deuxième filtre passe-bande destiné à laisser passer une sous-bande sélectionnée au sein de la bande radio DAB III et utilisant un deuxième dispositif transformateur selon la revendication 1.

# FIG. 1

# FIG. 2

FIG. 3

FIG. 4

FIG. 5

FIG. 6

FIG. 7

FIG. 8

FIG. 9

FIG. 10

FIG. 11

**FIG. 12**

**FIG. 13**

FIG. 14

FIG. 15

**FIG. 16**

**FIG. 17a**

FIG. 17b

FIG. 18

FIG. 19

| No | Name | Figures 2D /3D | L1 [nH] | L2 [nH] | k | Cin [pF] | Cout | Cx [pF] | fr1 | fr2 |
|---|---|---|---|---|---|---|---|---|---|---|
| 1 | 8 turns lateral | Figure 12 | 235 | 220 | 0.408 | 0.1 | 0.3 | 7.2 | 200 | 240 |
| 2 | 4 turns lateral wide | Figure 13 | 127 | 110 | 0.230 | 0.4 | 0.3 | 1.3 | 340 | 400 |
| 3 | lateral 4-3-4-3 turns | Figure 14 | 238 | 241 | 0.172 | 0.7 | 0.5 | 0.5 | 275 | 340 |
| 4 | lateral 4 double turns | Figure 15 | 218 | 219 | 0.295 | 1.1 | 0.9 | 1.2 | 200 | 220 |
| 5 | vertical top bottom | Figure 16 | 241 | 242 | 0.382 | 0.3 | 0.3 | 0.5 | 470 | >500 |
| 6 | spiral | Figure 17a | 277 | 267 | 0.770 | 0.4 | 0.4 | 1.2 | 280 | 370 |
| 7 | Spiral and series coils | Figure 18 | 302 | 302 | 0.508 | 0.3 | - | 0.8 | 200 | 240 |
| 8 | Spiral with ground shield | Figure 17b | 213 | 202 | 0.723 | 1.3 | 1.1 | 0.8 | 280 | 400 |

| No | Name | Area lx [mm] | Area ly [mm] |
|---|---|---|---|
| 1 | 8 turns lateral | 15 | 11 |
| 2 | 4 turns lateral wide | 16 | 10 |
| 3 | lateral 4-3-3-4 turns | 16 | 13 |
| 4 | lateral 4 double turns | 17 | 13 |
| 5 | vertical top bottom | 11 | 12 |
| 6 | spiral | 12 | 14 |
| 7 | Spiral and series coils | 21 | 13 |
| 8 | Spiral with ground shield | 13 | 15 |

# FIG. 20

EP 2 736 053 B1

FIG. 21

FIG. 22

## FIG. 23

## FIG. 24

FIG. 25

FIG. 26

FIG. 27

EP 2 736 053 B1

FIG. 28

FIG. 29

32

FIG. 30

FIG. 31a

FIG. 31b

FIG. 31c

FIG. 31d

FIG. 32

# FIG. 33

# FIG. 34

FIG. 35

EP 2 736 053 B1

FIG. 36

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 4203961 A1
- GB 1470695 A

- WO 03073550 A1